Europäisches Patentamt

European Patent Office

Office européen des brevets

(19)

(11) Veröffentlichungsnummer: **0 203 603**

**A1**

(12) # EUROPÄISCHE PATENTANMELDUNG

(21) Anmeldenummer: **86107294.0**

(22) Anmeldetag: **28.05.86**

(51) Int. Cl.⁴: **B23K 1/12**

(30) Priorität: **30.05.85 DE 3519396**

(43) Veröffentlichungstag der Anmeldung:
**03.12.86 Patentblatt 86/49**

(84) Benannte Vertragsstaaten:
**AT BE DE FR GB IT NL**

(71) Anmelder: **Siemens Aktiengesellschaft Berlin und München**
**Wittelsbacherplatz 2**
**D-8000 München 2(DE)**

(72) Erfinder: **Gutwirth, Werner, Dipl.-Phys.**
**Gunzenleestrasse 16 A**
**D-8901 Kissing(DE)**
Erfinder: **Schweizer, Matthias**
**Rochusweg 16**
**D-8894 Igenhausen(DE)**

(54) **Verfahren und Anordnung zur automatischen Lotzufuhr beim Stapellöten.**

(57) Die Erfindung bezieht sich auf ein Verfahren und auf eine Anordnung zur automatischen Lotzufuhr beim Stapellöten von zu Ösen geformten Drahtenden von Anschlußdrähten auf einer Lötstelle. Dabei soll eine stets gleichmäßig dosierte Zuführung der Lotmenge an der Lötstelle gewährleistet sein. Hierfür sieht die Erfindung vor, daß ein von einer Rolle kommendes Lotband (5) in definierten Schrittlängen durch ein Schnittwerkzeug, bestehend aus einem Zentrierstift (2) und einem Schnittstempel (6), geführt wird, das aus dem Lotband Ringe (3) ausschneidet, die mit dem Lötwerkzeug (1, 2) selbst der Lötstelle zugeführt werden, nachdem der Schnittstempel seine ursprüngliche Arbeitsposition verlassen hat. Das verbrauchte Lotband (5) wird auf einer zweiten Spule wieder aufgewickelt.

EP 0 203 603 A1

Verfahren und Anordnung zur automatischen Lotzufuhr beim Stapellöten

Die Erfindung betrifft ein Verfahren und eine Anordnung zur automatischen Lotzufuhr beim Stapellöten von zu Ösen geformten Drahtenden von Anschlußdrähten auf einer Lötstelle.

In der deutschen Patentanmeldung mit dem Aktenzeichen P .. .. ... wird eine Vorrichtung zum Stapellöten von zu Ösen geformten Drahtenden von Anschlußdrähten vorgeschlagen. Im Innern eines Lötbügels ist dabei ein federnd gelagerter Zentrierstift vorgesehen, der beim Lötvorgang als Halt dient und dadurch Stapellöten von übereinander angeordneten, zu Ösen geformten Drahtenden von Anschlußdrähten auf einer Lötstelle, z.B. von gedruckten Leiterplatten, ermöglicht. Bei einer derartigen Vorrichtung ist es erwünscht, eine automatische Lotzufuhr mit exakt dosierter Lotmenge zu erhalten.

Aufgabe der vorliegenden Erfindung ist es daher, ein Verfahren anzugeben und eine Anordnung zum Stapellöten zu schaffen, durch die eine stets gleichbleibende Dosierung des Lötzinns an der Lötstelle gewährleistet ist.

Zur Lösung dieser Aufgabe wird dabei so verfahren, daß ein von einer Rolle kommendes Lotband in definierten Schrittlängen durch ein Schnittwerkzeug, bestehend aus einem Zentrierstift und einem Schneidstempel geführt wird, das aus dem Lotband Ringe ausschneidet, die mit dem Lötwerkzeug selbst der Lötstelle zugeführt werden, nachdem der Schneidestempel seine ursprüngliche Arbeitsposition verlassen hat und daß das verbrauchte Lotband auf einer zweiten Spule wieder aufgewickelt wird.

Zur Durchführung des Verfahrens wird die Anordnung derart ausgebildet, daß eine Schnittplatte vorgesehen ist, über die das Lotband geführt ist, daß oberhalb der Schnittplatte ein schwenkbarer Lötbügel angeordnet ist, der einen Zentrierstift enthält, der soweit auf die Schnittplatte absenkbar ist, daß er gerade noch das Innenloch des zu erzeugenden Lotrings aus dem Lotband stanzt, daß unterhalb der Schnittplatte in genauer Position zum Zentrierstift ein Schnittstempel angeordnet ist, der beim Hochfahren den Lotring vollends aus dem Lotband ausstanzt und auf den Zentrierstift schiebt, der an seinem unteren Ende unscharfe Kanten aufweist.

In weiterer Ausgestaltung kann unterhalb des Schnittstempels eine Auffangvorrichtung für den Stanzabfall vorgesehen werden.

Durch die vorgegebene Geometrie der durch dieses Verfahren und Anordnung nach der Erfindung erhaltenen Lotringe ist die Lotmenge exakt definiert. Dabei läuft der Vorgang automatisch ab.

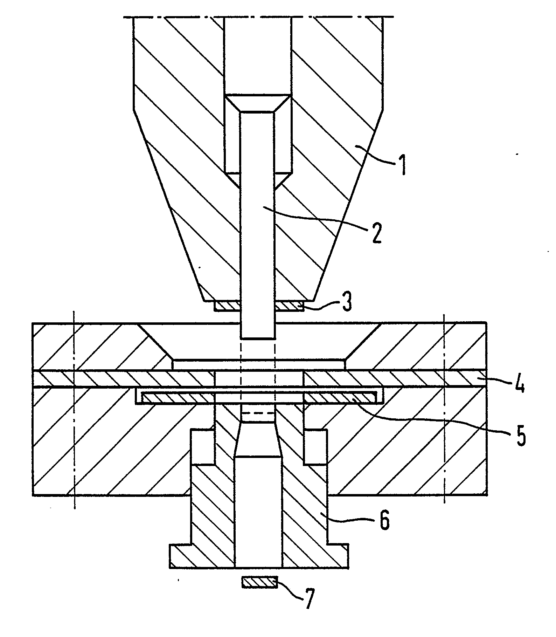

Anhand des Ausführungsbeispiels nach der Figur wird die Erfindung näher erläutert.

Das Lotband 5 wird von einer, in der Figur nicht dargestellten Rolle kommend, in definierten Schrittlängen durch das Schnittwerkzeug geführt - (senkrecht zur Zeichnungsebene) und auf einer zweiten, ebenfalls nicht gezeigten Rolle, wieder aufgespult.

Zur "Lotabholung" wird das Schnittwerkzeug genau unter dem Lötbügel 1 positioniert, der anschließend in Richtung Schnittplatte 4 abgesenkt wird, so daß der voreilende Zentrierstift 2 des Lötbügels 1 gerade noch das Innenloch des Lotrings 3 stanzt. Der nun hochfahrende Schnittstempel 6 stanzt an der Schnittplatte 4 den Lotring 3 aus dem Lotband 5 vollständig heraus und schiebt ihn am Zentrierstift 2 entlang bis zur Lötbügelsohle.

Durch unscharfe Schneidkanten am Zentrierstiftende wird erreicht, daß der Lotring 3 am Zentrierstift 2 festgeklemmt bleibt und nicht herabfallen kann. Der Stanzabfall 7 wird unten aufgefangen.

Nach dem Hochfahren des Lötbügels 1 verläßt das Schnittwerkzeug die Position "Lotabholung". Danach kann der Lötbügel 1 mit dem Lotring 3 auf die Lötstelle (Leiterplatte) abgesenkt werden.

Alle Vorgänge werden von der Lötkopfsteuerung koordiniert.

**Ansprüche**

1. Verfahren zur automatischen Lotzufuhr beim Stapellöten von zu Ösen geformten Drahtenden von Anschlußdrähten auf einer Lötstelle, **dadurch gekennzeichnet**, daß ein von einer Rolle kommendes Lotband (5) in definierten Schrittlängen durch ein Schnittwerkzeug, bestehend aus einem Zentrierstift (2) und einem Schnittstempel (6) geführt wird, das aus dem Lotband Ringe (3) ausschneidet, die mit dem Lötwerkzeug (1, 2) selbst der Lötstelle zugeführt werden, nachdem der Schnittstempel (6) seine ursprüngliche Arbeitsposition verlassen hat und daß das verbrauchte Lotband (5) auf einer zweiten Spule wieder aufgewickelt wird.

2. Anordnung zur Durchführung des Verfahrens nach Anspruch 1, **dadurch gekennzeichnet**, daß eine Schnittplatte (4) vorgesehen ist, über die das Lotband (5) geführt ist, daß oberhalb der Schnittplatte (4) ein schwenkbarer Lötbügel (1) angeordnet ist, der einen Zentrierstift (2) enthält, der soweit auf die Schnittplatte (4) absenkbar ist, daß er gerade noch das Innenloch des zu erzeugenden Lotrings aus dem Lotband stanzt, daß unterhalb der Schnittplatte (4) in genauer Position zum Zentrierstift (2) ein Schnittstempel (6) angeordnet ist, der beim Hochfahren den Lotring vollends aus dem Lotband ausstanzt und auf den Zentrierstift (2) - schiebt, der an seinem unteren Ende unscharfe Kanten aufweist.

3. Anordnung nach Anspruch 1 oder 2, **dadurch gekennzeichnet**, daß unterhalb des Schnittstempels (6) eine Auffangvorrichtung für den Stanzabfall vorgesehen ist.

## EINSCHLÄGIGE DOKUMENTE

EP 86107294.0

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | DE - B - 2 039 388 (ERIE)<br>* Fig. 2-4 *<br><br>-- | 1 | B 23 K 1/12 |
| A | US - A - 4 300 715 (KEIZER)<br>* Fig. 5-40 *<br><br>-- | 1,2 | |
| A | US - A - 4 429 458 (SHIBATA)<br>* Fig. 6-10 *<br><br>---- | 1 | |

|  |
|---|
| **RECHERCHIERTE SACHGEBIETE (Int. Cl.4)** |
| B 23 K 1/00 |
| B 23 K 3/00 |
| B 23 K 31/00 |
| H 05 K 3/CO |
| H 01 R 4/00 |
| H 01 R 43/00 |

Der vorliegende Recherchenbericht wurde für alle Patentansprüche erstellt.

| Recherchenort | Abschlußdatum der Recherche | Prüfer |
|---|---|---|
| WIEN | 04-09-1986 | BENCZE |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82